# EUROPEAN PATENT APPLICATION

(11) **EP 1 538 234 A2**
(43) Date of publication of application: **08.06.2005**
(21) Application number: 04028302.0
(22) Date of filing: 30.11.2004
(51) Int. Cl.: C23C 16/40, C23C 16/448, C23C 16/46

(54) **Method of modifying solid surface and product obtained**

(30) Priority: 01.12.2003 JP 2003401679
(71) Applicant: Yasuhiro, Mori, Tokyo 135-0042 (JP)
(72) Inventor: Yasuhiro, Mori, Tokyo 135-0042 (JP); Mikio, Yamashita, Koriyama-shi Fukushima-ken 963-8051 (DE)
(74) Representative: Hoffmann, Eckart, Dipl.-Ing.

(57) **Abstract**

A method of modifying a solid surface from non-adhesive to adhesive and a solid material are provided. In a method of modifying a solid surface, a gaseous mixture comprising a modifier compound containing at least silane atom, titanium atom or aluminum atom is sprayed on the solid surface while the gaseous mixture is heated to 400°C or more with a heat source, or a gaseous mixture comprising a compound containing at least a silane atom, a titanium atom, or an aluminum atom is sprayed on the solid surface, and then the solid surface is heated to 400°C or more.

## Description

### Field of the invention

The present invention relates to a method of modifying a solid surface and a surface-modified solid material, and more specifically to a method of modifying a solid surface that makes adhesion, printing, coating, or the like on the solid surface easy without directly using a flame treatment and to a surface-modified solid material.

### Background of the invention

Most of solid materials such as silicone rubber, fluorine rubber and a polyethylene resin have hydrophobic or water-shedding surfaces, respectively. Therefore, in general, their surfaces are hardly subjected to surface finishing treatments such as adhesion to another material, printing, and UV coating. The surface of a metal such as stainless steel or magnesium is insufficient in adhesiveness or surface smoothness, compared with other metals. Therefore, such a metal poses a problem in that a coating layer formed on the metal by directly applying UV curing lacquer thereof can be easily peeled off. An attempt of adding an inorganic fine particle such as titanium oxide or zirconium oxide as a photo-catalyst to a polymer material also poses problems of lack in dispersibility and difficulty in handling.

Conventionally, as a method of modifying the surface of a material (hereinafter, also referred to as a solid surface), a primer treatment to a solid surface or the application of a silane coupling agent or titanium coupling agent dissolved in a solvent to a solid surface has been carried out.
However, these methods pose problems in production in that there are requirements of relatively a lot of amount of a primer or a silane coupling agent and an extended manufacturing time.

Other methods of modifying the property of a solid surface in stead of the primer or coupling agent treatment include an UV radiation, corona discharge, plasma treatment, sandblast, surface functional group addition, surface light graft, solvent treatment, and chromate mixture treatment.

These surface modification methods, however, result in sufficient modification of the solid surfaces with respect to their surface properties and cause environmental problems such as the pollution of a workplace, problems in process such as the lack of safety or the requirement of disposal of a lot of waste, and economical problems such as the requirement of large-scale and expensive facilities.

As a simple and cost-effective method for surface modification, a flame treatment on a solid surface has been also proposed (see, e.g., JP 9-124810 A).

The inventors of the present invention have proposed another surface modification method (silicone oxidizing flame treatment, titanium oxidizing flame treatment, and aluminum oxidizing flame treatment) where flame formed from fuel gas containing amodifier compound having a certain boiling point is sprayed on a solid surface (see, e.g., WO 03/069017). This method can modify the solid surface evenly and sufficiently due to an effective combustion of the modifier compound having a silane atom or the like even if the modifier compound is used in large amount.

### Disclosure of the invention

### Problems to be resolved by the invention

However, the method described in JP 9-124810 A shows a poor effect on the modification of the properties of a solid surface, such as surface tension or a contact angle. Besides, such an effect cannot be persisted for a long time. Moreover, there is another problem in that a solid material thus treated tends to be deformed by heat. The method also has difficulty in treating a solid material evenly with the use of flame directed downwardly. Furthermore, a gaseous mixture is often ignited or the flame is often extinguished during the treatment in order to save a fuel gas consumption. However, such a fact imposes a lot of load on an ignition device or the like. In addition, it causes other problems in that a surface treatment machine itself is grown in size and requires frequent maintenance and safety-checks for mass-production. The method described in WO 03/069017is a surface treatment that provides a solid surface with effective and long-durable modified properties. However, in the method, flame is also used, so that there is a limitation in the flame direction just as in the case of JP 9-124810 A. In addition, there is another limitation that a modifier compound having a certain boiling point must be used in consideration of its combustion performance.

The present invention provides a method of modifying a solid surface using a certain modifier compound that enables to treat the solid surface evenly and effectively and also provides a surface-modified solid material.

According to the present invention, the above problems can be solved by providing a method of modifying a solid surface, wherein a gaseous mixture comprising a modifier compound containing at least a silane atom, a titanium atom or an aluminum atom is sprayed on the solid surface while the gaseous mixture is heated to 400°C or more with a heat source, or a gaseous mixture comprising at least a compound containing silane atom, a titanium atom or an aluminum atom sprayed is sprayed on the solid surface, followed by heating the solid surface to 400°C or more. SiH₄, for example, is decomposed to a Si and H₂ when heated at a range of 700 to 1000°C.

In addition, SiH₄ gas is oxidized by heating about 400°C and combined with O₂ to form SiO₂ and H₂. By proceeding these reactions effectively, a SiO₂ particle having hydrophilicity on its surface can be formed on the surface or in the inside area of the solid material from a gaseous mixture containing at least a Si atom, for example, in a gaseous mixture.

According to another embodiment of the present invention, furthermore, the above problems can be solved by providing a method of modifying a solid surface, wherein a gaseous mixture comprising at least a modifier compound containing a silane atom, a titanium atom or an aluminum atom is sprayed on the solid surface while the gaseous mixture is heated to 400°C or more with a heat source, and the solid surface is then heated to 400°C or more with the heat source or another heat source.

It is preferable that the heat source described above is an apparatus selected from a group consisting of a laser, a halogen lamp, an infrared lamp, a high-frequency coil, an induction heating apparatus, a hot air heater, and a ceramic heater.

It is also preferable that the modifier compound is selected from a group consisting of alkyl silane, alkoxy silane, alkyl titanium, alkoxy titanium, alkyl aluminum, and alkoxy aluminum when the present solid surface treatment method is carried out.

It is preferable that the content of the modifier compound in the gaseous mixture ranges from 1 × 10⁻¹⁰ mol% to 10 mol% with respect to 100% by mole of the gaseous mixture in total when the present surface treatment method is carried out.

In addition, it is preferable that the gaseous mixture is prepared by mixing the modifier compound with air.

It is also preferable that the gaseous mixture is sprayed at a low pressure of 1 × 10⁻³ Pa to 1 × 10⁻¹⁰ Pa.

It is preferable that the gaseous mixture is sprayed at a high pressure of 1 × 10² Pa to 1 × 10⁷ Pa.

It is preferable that the gaseous mixture is sprayed for 0.1 sec to 100 sec per unit area (100cm²).

Another embodiment of the present invention is a surface-modified solid material, prepared such that
a gaseous mixture comprising a modifier compound containing at least a silane atom, a titanium atom or an aluminum atom is sprayed on the surface of a solid material while the gaseous mixture is heated to 400°C or more with a heat source or
a gaseous mixture comprising a modifier compound containing at least a silane atom, a titanium atom or an aluminum atom is sprayed on the surface of a solid material, followed by heating the surface of the solid material to 400°C or more with a heat source, whereby
the resulting surface-modified solid material has a surface tension (measured at 25°C) of 40 to 80 dyn/cm.

A still another embodiment of the present invention is a surface-modified solid material, prepared such that a gaseous mixture comprising a modifier compound containing at least a silane atom, a titanium atom or an aluminum atom is sprayed on the surface of a solid material while the gaseous mixture is heated to 400°C or more with a heat source and then the solid material sprayed with the gaseous mixture is heated to 400°C or more with the heat source or another heat source whereby the resulting surface-modified solid material has a surface tension (measured at 25°C) of 40 to 80 dyn/cm.

### Effect of the Invention

The method of modifying a solid surface of the present invention (also referred as a first surface treatment) allows the solid surface to be modified evenly and easily by a certain modifier compound by use of a heat source with a certain temperature. A silane compound, a titanium compound, or the like is easily decomposed by the method Also, particles of silica or titanium oxide are formed on the surface or in the inside area of the solid material. The formation of the particles provides the surface of the solid material with hydrophilicity and surface roughness, so that the adhesiveness of the surface to a chemical material such as an ink, lacquer or adhesive can be improved. Accordingly, the present method provides the solid surface with a higher surface tension (wettability) (measured at 25°C) of, for example, 40 to 80 dyn/cm. That is, the present method makes the solid surface hydrophilic. No use of flame in the method allows the gaseous mixture to be sprayed from every direction to the solid material, resulting in an evenly-modified surface of the solid material. As no use of flame eliminates the work of ignition of the gaseous mixture and extinction, the installation of an apparatus for a flame treatment including a supplying device of the gaseous mixture is not required. Thus, the surface treatment machine can be smaller in size, so that it is maintained easily.

According to the other solid surface modification method (also referred as second surface modificationmethod) of the present invention, the certain modifier compound absorbed on the solid material is heated to a certain temperature and decomposed to form particles on the solid surface. By these particles, the solid surface obtains hydrophilicity and surface roughness. In this second method, the gaseous mixture can be sprayed or applied from every direction because of no use of flame. This method does not require ignition of the gaseous mixture or extinction of the flame, which is not used, making it possible to design the machine used for the method smaller. Furthermore, the use of a heating apparatus that can heat a small area such as a laser allows a surface having nano-paterning or a surface of a fine-finished part used in a semiconductor device or the like to be treated by a spot-heating.

According to the other solid surface modification method (also referred as third surface modification method) of the present invention, a gaseous mixture comprising a modifier compound containing at least a silane atom, a titanium atom, or an aluminum atom is sprayed on the solid surface while the gaseous mixture is heated to 400°C or more with a heat source, , followed by heating the solid surface to 400°C or more with the heat source or another heat source. Consequently, a smaller amount of a residual component of the modifier compound is found.

In the solid surface modification methods (first, second, and third surface modification methods) of the present invention, the use of a certain heat source (heating apparatus) enables a certain modifier compound to be decomposed easily and rapidly and the surface treatment machine for the method to be smaller and simpler.

Also, the use of a certain modifier compound enables to adhere strongly a solid surface having difficulty in adhesion such as silicone rubber or fluorine rubber with general glue, and to coat stably the solid surface with an ink or a coating composition including UV lacquer. In addition, the use of these compounds as a modifier compound makes the duration of the effects of the surface modification longer. These modifier compounds provide the particles having an excellent transparency. Moreover, these modifier compounds can be vaporized easily, so that the solid surface can be modified more evenly and easily.

In the solid surface modification methods (first, second, and third surface modification methods) of the present invention, the use of a gaseous mixture containing certain concentration of the modifier compound provides a surface modification effect, for example, even if the surface is made from a conducting solid or colorized solid, without deteriorating an original property such as conductivity or color.

In the solid surface modification methods (first, second and third surface modification methods) of the present invention, carrying out the surface treatment under certain low pressure results in an evenly-spraying treatment with the gaseous mixture containing certain modifier compound to the solid. The low pressure treatment makes CVD process, sputtering process, vapor deposition process, or the like to be ready rapidly when these processes are carried out after the treatment. The solid surface is modified evenly and sufficiently by the low pressure treatment, so that a thin layer made of a metal such as Cu, Al, W, Nb, Si, and Pt; metal alloys such as Ta-Nb and Ti-Ta; carbide such as TiC, ZrC and WC; nitride such as TiN and TaN; boride such as TaB and WB; silicide such as MoSi and TiSi; oxide such as Al₂O₃ and Ta₂O₅; or the like is strongly formed onto the solid surface.

In the solid surface modification methods (first, second and, third surface modification methods) of the present invention, carrying out the surface treatment under certain high pressure enables temperature surrounding this system to be high easily, so that a certain modifier compound can be heated rapidly or load of a heat source that heats the system can be reduced.

In the solid surface modification methods (first, second, and third surface modification methods) of the present invention, certain time of the treatment, which will be described later, limits the range of the amount of the particles formed by the treatment, and modifies the solid surface at low cost effectively.

According to the surface modified solid material of the present invention (also referred as a first surface-treated solid material), a particle is formed on the solid surface and partly in the solid, so that the surface can be strongly adhered by a usual adhesive. Also, an ink for printing, UV lacquer or inorganic-thin film formable material is strongly adhered to the surface.

According to the solidmodified its surface of the present invention (also referred as a second surface treated solid material) , the formation of particles by heat-degradating a certain modifier compound after it have been absorbed on the solid ensures strong adhesion between the solid material and an ink for printing, UV lacquer, or inorganic-thin film formable material. The second surface treated solid material can be easily subjected to the surface modification everywhere. This allows a solid material with a line- or dot-like patterned modified area such its surface to be provided.

According to the surface modified solid material of the present invention (also referred as third surface-treated solid material), a particle is formed on the solid surface and partly in the solid, in addition, the formation of particles by heat-degradating a certain modifier compound after it have been absorbed on the solid material ensures strong adhesionbetween the solidmaterial and an ink forprinting, UV lacquer or inorganic-thin film formable material even if the modifier compound is a mixture of two or more compound and reactivity of these compounds vary within a certain range.

### Brief description of the drawings

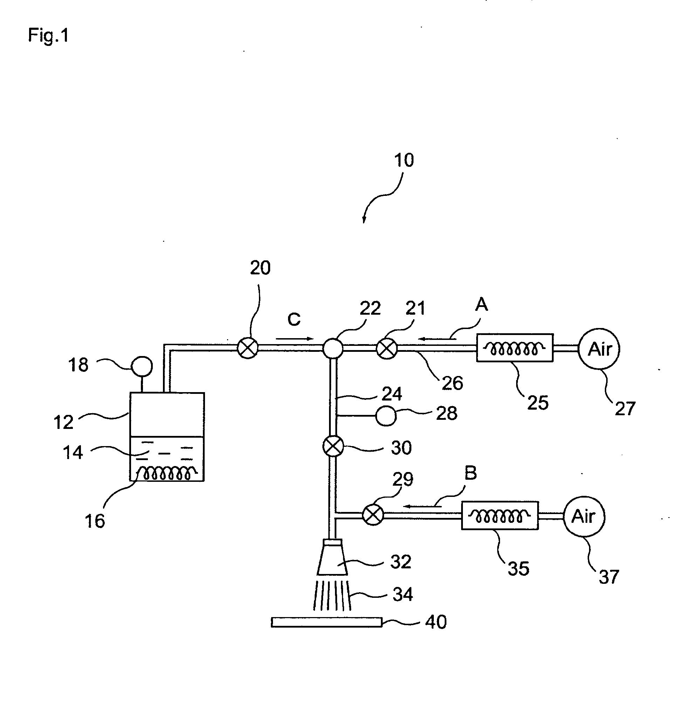

Fig.1 is a diagram for explaining a surface treatment machine of the present invention.
Fi.2 is a diagram for explaining a surface treatment machine of the present invention.
Fi.3 is a diagram for explaining a surface treatment machine of the present invention.
Fi.4 is a diagram for explaining a surface treatment machine of the present invention.
Fi.5 is a diagram for explaining a surface treatment machine of the present invention.

### The Best Mode for Carrying Out the Invention

Next, the modification method for the surface of a solid material and the modified surface thereof in accordance with the present invention will be explained in detail. The third surface modification method or third surface-treated solid material is a combination of first and second surface modification methods or a combination of first and second surface-treated solid materials, respectively, so that explanation for the third method and solid material will be not found in the following description.

### Embodiment 1

The first embodiment is a method of modifying a solid surface, wherein a gaseous mixture comprising a modifier compound containing at least silane atom, titanium atom or aluminum atom is sprayed on the solid surface while the gaseous mixture is heated to 400°C or more with a heat source (first surface modification method), or a method, wherein a gaseous mixture comprising a compound containing at least a silane atom, a titanium atom, or an aluminum atom is sprayed on the solid surface, and then the solid surface is heated to 400°C or more (second surface modification method).

### 1. Solid Material

A solid material used in the first embodiment is the same material as one used in a second embodiment of the present invention that will be explained later.

### 2. Gaseous Mixture

### (1) Modifier compound

### (1)-1 Boiling point

The modifier compound preferably has a boiling point in a range of 10 to 200°C. In the case that a modifier compound has a boiling temperature less than 10°C, it may be difficult to carry out the surface modification treatment or the like process necessary to carry out the treatment because of their highly-volatile property. In the case that a modifier compound has a boiling temperature more than 200°C, it may be difficult to mix these compounds with air, resulting in uneven modification of the solid surface or difficulty maintaining the modification effect for a long time. From these reasons, a compound having a boiling point at a range from 15 to 180°C is preferably selected as the modifier compound, and more preferably from 20 to 120°C. The boiling point of the modifier compound can be adjusted by modifying the chemical structure thereof. In addition, a silane compound having relatively high boiling point and a liquid material having a relatively low boiling point can be combined to use when the mixture shows an azeotropy.

### (1)-2 Molecular species

A Kind of the modifier compound is not limited. Example of the modifier compound includes an alkyl silane compound, an alkoxy silane compound, an alkyl titanium compound, an alkoxy titanium compound, an alkyl aluminum compound and alkoxy aluminum. Of these examples, alkyl derivatives of silane compound, titanium compound, or aluminum compound are preferable as a modifier compound because of a lower boiling point which enables them to be easily vaporized by heating and mixed well with air or the like.

Examples of the silane compound include tetramethylsilane, tetraethylsilane, dimethyldichlorosilane, dimetyldiphenylsilane, diethyldichlorosilane, diethyldiphenylsilane, methyltrichlorosilane, methyltriphenylsilane, dimethldoethylsilane, tetramethoxysilane, tetraethoxysilane, methyltrimethoxysilane, dimethyldimethoxysilane, phenyltrimethoxysilane, dichlorodimethoxysilane, dichlorodiethoxysilane, diphenyldimethoxysilane, diphenyldiethoxysilane, trichloromethoxysilane, trichloroethoxysilane, triphenylmethoxysilane, and triphenylethoxysilane. These compounds are used alone or in a combination of two or more.

Examples of the titanium compounds include tetramethyltitanium, tetraethyltitanium, dimethyldichlorotitanium, dimetyldiphenyltitanium, diethyldichlorotitanium, diethyldiphenyltitanium, methyltrichlorotitanium, methyltriphenyltitanium, dimethldoethyltitanium, tetramethoxytitanium, tetraethoxytitanium, methyltrimethoxytitanium, dimethyldimethoxytitanium, phenyltrimethoxytitanium, dichlorodimethoxytitanium, dichlorodiethoxytitanium, diphenyldimethoxytitanium, diphenyldiethoxytitanium, trichloromethoxytitanium, trichloroethoxytitanium, triphenylmethoxytitanium, andtriphenylethoxytitanium. These compounds are used alone or in a combination of two or more.

Examples of the aluminum compounds include trimethylaluminum, triethylaluminum, dimethylchloroaluminum, dimetylphenylaluminum, diethylchloroaluminum, diethylphenylaluminum, methyldichloroaluminum, methyldiphenylaluminum, dimethlethylaluminum, trimethoxyaluminum, triethoxyaluminum, methyldimethoxyaluminum, dimethylmethoxyaluminum, phenyldimethoxyaluminum, dichloromethoxyaluminum, dichloroethoxyaluminum, diphenylmethoxyaluminum, phenylethoxyaluminum, dichloromethoxyaluminum, dichloroethoxyaluminum, diphenylmethoxyaluminum, and diphenylethoxyaluminum. These compounds are used alone or in a combination of two or more.

The silane compound or the like as the modifier compound of the present invention preferably has nitrogen atom, halogen atom, a vinyl group, and an amino group.

The silane compound of the present invention specifically preferably at least a compound selected from a group of hexamethyldisilazane (b.p. 126°C), vinyltrimethoxysilane (b.p. 123°C), vinyltriethoxysilane (b.p. 161°C), trifluoropropyltrimethoxysilane (b.p. 144°C), trifluoropropyltrichlorosilane (b.p. 113-114°C), 3-aminopropyltrimethoxysilane (b.p. 215°C), 3-aminopropyltriethoxysilane (b.p. 217°C), hexamethyldisiloxane (b.p. 100-101°C), and 3-chloropropyltrimethoxysilane (b.p. 196°C).

The reason why the above examples are preferably selected is that these silanes show superior mixability to a carrier gas, resulting in more uniform modification of a solid surface by forming particles (silicate layer). Moreover, the range of the boiling points of these compounds show the tendency of maintaining these silane compounds on the solid surface, resulting in a better adhesiveness between the solid material and a coating layer formed from various UV curable resins or the like.

### (1)-3 Average of molecular weight of the components of modifier compound

In the present invention, the modifier compounds preferably have an average value of their molecular weights of 50 to 1000 measured by mass-spectrum measurement. The reason of this is that if the average value of their molecular weights is lower than 50, it is difficult to carry out the surface modification treatment by their highly-volatile property. By contrast, if the average value of their molecular weights is higher than 1000, it is probably difficult to mix these compounds with air or the like by heating. From these reasons, the modifier compounds preferably have an average value of their molecular weights of 60 to 500, or more preferably 70 to 200 measured by mass-spectrum measurement.

### (1)-4 Amount of addition

In the present invention, the amount of the added modifier compound is preferably set to 1 × 10⁻¹⁰ to 10 mol% when the amount of the gaseous mixture (including the modifier compound) is decided to 100%. In the case that the amount of the added modifier compound is set to less than 1 × 10⁻¹⁰ mol%, the modification effect of the treatment is not always emerged. In the case that the amount of the added modifier compound is set to more than 10 mol%, the mixability of the modifier compound with air may be reduced, resulting in a poor oxidation of the modifier compound.
From these reasons, the amount of the added modifier compound is preferably set to 1 × 10⁻⁹ to 5 mol% when the amount of the gaseous mixture (including the modifier compound) is set to 100%, or more preferably 1 × 10⁻⁸ to 1 mol%.

### (2) Carrier gas

A carrier gas such as air and oxygen is preferably combined to use with the modifier compound in order to blow the modifier compound evenly to the solid material and to decompose the modifier compound easily then to oxidize. An inert gas such as argon, nitrogen, or vaporized carbon fluoride is also preferably used as the other carrier gas with the air or oxygen. This reason is that the use of these carrier gases enables the modifier compound to be transported precisely and smoothly. The amount of the carrier gas mixed to the modifying gas is preferably set to 80 to 90 mol% when the total amount of the gaseous mixture is set to 100mol%. In the case that the amount of the carrier gas is set to less than 80 mol%, the carrier gas sometimes does not mix well with the modifier compound. With this lower mixability, evenly spraying may become difficult.

By contrast, in the case that the amount of the carrier gas is set to more than 99.9 mol%, the modification effect of the treatment to the solid material is not always emerged.

From these reasons, the amount of the carrier gas is preferably set to 85 to 99 mol% when the amount of the gaseous mixture (including the modifier compound) is set to 100%, or more preferably 90 to 99 mol%.

The gaseous mixture containing modifier compound and carrier gas may contain the other gas such as carbon hydride gas as the third component, for example, 1 to 10 mol% when the total amount of the gaseous mixture is set to 100%, and this case is also preferable.
In case that the carrier gas is at a high temperature, the carrier gas can be used as a heat source in order to oxidize a certain modifier compound in the present invention.

### 3. Heat source

### (1) Temperature

The heat source is preferably controlled at the temperature range from 400 to 2500°C. The reason of this is that if the temperature of the heat source is less than 400°C, it tends to be difficult to form particles on the solid surface. By contrast, if the temperature of the heat source is more than 2500°C, the gaseous mixture may be excessively heated, causing heat-deformation or heat-deterioration of the solid material which is an obj ect for the surface treatment. From these reasons, the temperature of the heat source is preferably set to 500 to 800 °C, or more preferably 800 to 1200 °C.

### (2) Kind of the heat source

The kind of the heat source is not limited to a special apparatus. For example, the heat source is preferably selected at least one from a group of a laser, halogen lamp, infrared lamp, high-frequency coil, induction heating apparatus, hot-air heater, or ceramic heater. A laser, for example, can decompose the modifier compound at a small spot extremely rapidly. The treatment for the small spot like this enables to form nano-paterned structure on the semiconductor substrate surface as a targeted solid surface.

A halogen lamp or an infrared lamp can decompose a large amount of the modifier compound because of its highly uniform temperature distribution. Olefinic film or the like can be effectively treated as a solid material by the halogen lamp or the infrared lamp.

A high-frequency coil or induction heating apparatus can also decompose the modifier compound extremely rapidly by heating extremely quickly, providing metal parts or the like with an effective surface treatment property.

A hot-air heater or a ceramic heater enable a solid material in wide range of sizes, from a small scale to large scale, to be treated at a high temperature of more than 2000°C, so that it is easy to decompose the modifier compound, and an effective surface treatment of a ceramic substrate or the like becomes possible.

### 4. Condition of surface treatment

### (1) Time for treatment

Time for spraying the gaseous mixture containing the modifier compound is preferably set to a time ranging from 0.1 sec to 100 sec per unit area (100cm²). In the case that the time for spraying is less than 0.1 sec, the modification effect by the modifier compound to the solid material is not always evenly emerged. By contrast, in the case that the time for spraying is more than 100 sec, the solid material may be excessively heated, causing heat-deformation or heat-deterioration of the solid material which is an object for the surface treatment. This may excessively limit kinds of the solidmaterial available. From these reasons, the time for spraying to a unit area (the unit area means 100cm² in this document) is preferably set to 0.3 to 30 sec, or more preferably 0.5 to 20 sec.

In the case that a gaseous mixture containing the modifier compound is sprayed on the solid surface then the solid surface is heated with a heat source to oxidize the modifier compound, the time for spraying is not limited within the range mentioned above, that is, the time can also be 100sec or more, because the spray of the gaseous mixture gives little thermal influence to the solid material.

### (2) Pressure 1

The gaseous mixture containing certain modifier compound is preferably sprayed to solid material for the surface treatment under a low pressure of 1 × 10⁻³ to 1 × 10⁻¹⁰ . The reason of this is that the surface treatment under such certain low pressure enables uniform spraying to the solid material. Also, the surface treatment under such certain low pressure makes it easy to carry out next process such CVD, spattering and vapor deposition because of the surface treatment has already been carried out a low pressure. However, if a pressure becomes too low, oxidation reaction or decomposition reaction on the solid surface does not always undergo sufficiently.

From these reasons, the gaseous mixture is preferably sprayed to a solid material at a low pressure ranging from 1 × 10⁻⁴ to 1 × 10⁻⁸ Pa, more preferably from 1 × 10⁻⁵ to 1 × 10⁻⁷ Pa.

Even if the oxidation reaction on the solid surface does not undergo sufficiently by spraying a heated gaseous mixture under the low pressure, the solid surface is sufficiently modified by mixing larger amount of oxygen, by applying higher temperature, or by spraying the gaseous mixture again under a higher temperature and higher pressure. In case that the gaseous mixture with high temperature is sprayed under such low pressure, heating can be carried out separately to the spraying to carry out the sufficient surface treatment.

### (3) Pressure 2

The certain gaseous mixture is preferably spraying to the solid material for the surface treatment under a high pressure of 1 × 10² to 1 × 10⁷. Because the surface treatment under such certain high pressure makes it possible to set easily the temperature around the surrounding atmosphere high, so that it is possible to heat the certain compound quickly or to reduce a load for the heat source.

### 5. Surface treatment machine

### (1) General structure

A surface treatment machine of the present invention for the surface treatment of Example 1 is preferably equipped with a storage tank 12 for storing a modifier compound 14, a transport section 24 for transporting the modifier compound vaporized (also referred as first gaseous mixture) to a certain place, a heat source 25 for heating a carrier gas in order to control the first gaseous mixture at a certain temperature, and a spraying part 32 for spraying the gaseous mixture (also referred as second gaseous mixture) containing the modifier compound 14 and controlled at the certain temperature as shown in Fig. 1. This machine enables the second gaseous mixture, which is controlled at a certain temperature and containing the modifier compound, can be sprayed to a solid material from various directions, resulting in a sufficient treatment of the solid material. This machine uses no flame and does not require ignition or extinction during the surface modification treatment, so that the machine can be designed in a small size.

Moreover, there is no need to consider combustion property of the modifier compound. This reduces the number of limitations for the modifier compound.

The surface treatment machine of the present invention is preferably equipped with the first storage tank 12 for storing a modifier compound 14 and the second storage tanks 27, 37 for storing a carrier gas such as compressed air as shown in Fig. 1. In this example, the machine has heating apparatus 16 such as a heater at the lower place of the first storage tank 12, and this arrangement is preferable so as to vaporize the modifier compound that is liquid state under an ambient temperature and pressure. When a solid surface is treated by the surface treatment, the modifier compound 14 in the first storage tank 12 is heated with a heating apparatus 16 to a certain temperature to be vaporized, and the vaporized modifier compound is transported as indicated by arrow C and mixed with the carrier gas in a heated state to be the gaseous mixture with a certain temperature. Because the content of the modifier compound 14 in the gaseous mixture is very important, in order to regulate the content quantity of the modifier compound, it is preferable to install a pressure gauge (or level gauge for monitoring a liquid surface) 18 for monitoring the vapor pressure of the modifier compound (or the amount of the modifier compound).

The transport section 24 has a tube-like structure in general. As shown in Fig. 1, the transport section 24 comprises a mixing room 22 where the modifier compound 14 as the first gaseous mixture transported from the first storage tank 12 with the carrier gas (compressed air) transported from the second storage tank 27, 37 after heated with the heat source (first heat source25) to make the second gaseous mixture, and preferably valves 20, 30 for regulating flows of the gases, a flow meter (not shown in the figure) , and a pressure gauge 28 for controlling the pressure of the first and second gaseous mixture.

For precise control of the temperature of the second gaseous mixture, a second heat source 35 is preferably placed in the course of the transport section 24 to introduce the carrier gas in heated state as shown by arrow B. This second heat source 35 can also be same one as the example of the first heat source 16 described above

The spraying part 32 preferably comprises the burner-like shaped thing or nozzles for an air gun or the like for spraying the second gaseous mixture with a certain temperature transported through the transport section 24 to a solid material 40 as a target material to be treated. A burner itself can be available in case that burner flame is being kept away from the solid material 40 during the treatment.

### (2) Modified Example 1

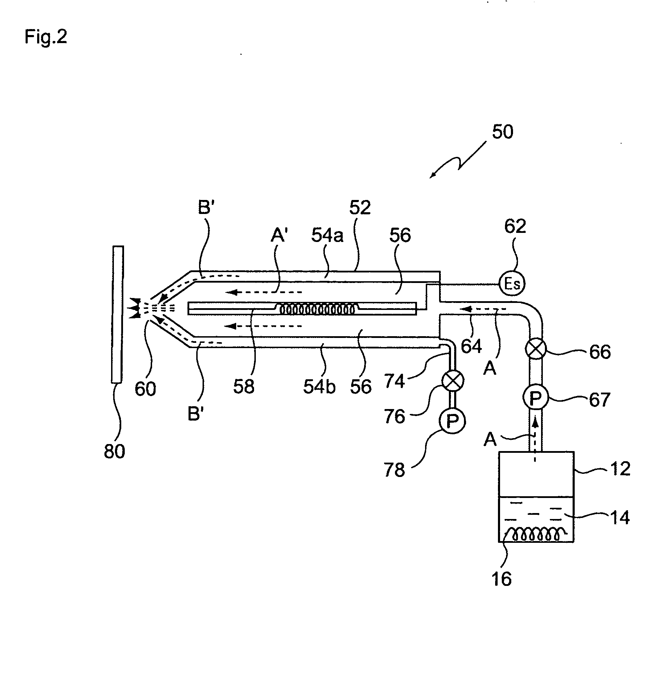

A surface treatment machine 50 having a needle-like spraying part is also preferably used as a modified example of the surface treatment machine of the present invention as shown in Fig. 2 . The surface treatment machine 50 having the needle-like spraying part is also preferably used. The surface treatment machine comprises a storage tank 12, which is equipped with a heater 16 to heat the modifier compound 14 to a certain temperature, for storing the modifier compound 14, a pump 67 for transporting the first gaseous mixture of the modifier compound 14 that is in a vaporized state, flow control valve 66 that controls the volume of the flow of the modifier compound 14, transport tube 64, and a heating room 56 for the modifier compound 14 connected to the transport tube 64. The heating room 56 is equipped with a heat source 58 for heating the first gaseous mixture of the modifier compound 14 to a certain temperature and a power supply 62 for controlling the heat source 58 placed outside the heating room 56. In fig. 2, arrow A shows the direction of flow of the vaporized modifier compound 14 from the storage tank 12, and arrow A' shows the flow of the modifier compound 14 in the heating room 56. This surface treatment machine 50 having needle-like spraying part also comprises a pump 78 for transporting the carrier gas for oxidizing the modifier compound 14, a flow control valve 76 for controlling the flow volume of the carrier gas, induction channels 54a, 54b surrounding the heating room 56, spraying part 60 for mixing the modifier compound 14 heated to a certain temperature with carrier gas and spraying the mixed gas to a solid material 80. From these structures explained above, the present surface treatment machine 50 having the needle-like spraying part 60 evenly mixes the modifier compound 14 that is transported in the direction as indicated by arrow A' with the carrier gas that is transported in the direction as indicated by arrow B near the spraying part 60, enabling the second gaseous mixture that is controlled within a certain temperature to be sprayed from various directions. Moreover, the surface treatment machine 50 can be designed in compact size, that is, for a handy-type.

### (3) Modified Example 2

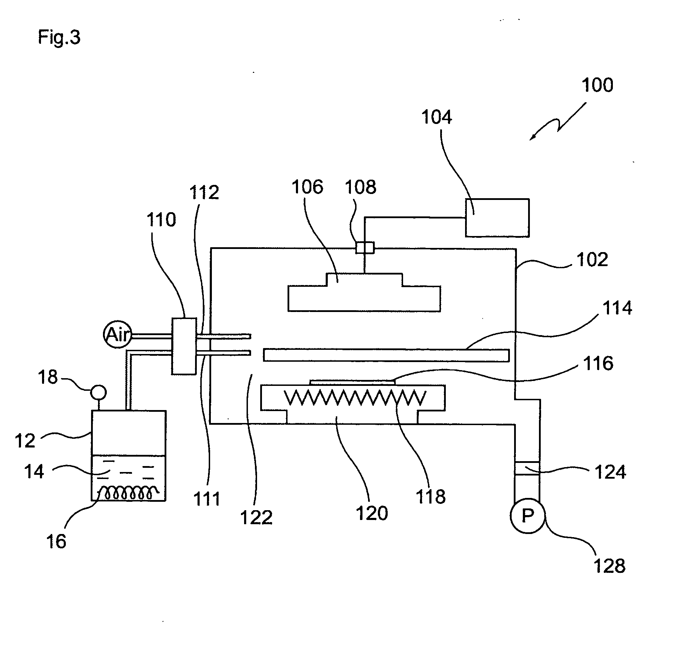

A surface treatment machine 100 having a function of pressure regulation is also preferably used as another example of the surface treatment machine of the present invention as shown in Fig.3. In the surface treatment machine 100 having a function of pressure regulation, an electrode for applying a high-frequency wave (also referred as high-frequency wave applying electrode) 106 and an earth electrode 120, both are a flat electrode, are placed in parallel. A high-frequency wave generator 104 is connected to the high-frequency wave applying electrode 106 through seal section 108, enabling to add frequency. A solid material 116 is placed above the earth electrode 120. The machine 100 is designed for enabling to regulate the temperature of the solid material 116 to a certain temperature by use of a ceramic heater 118 implanted in the earth electrode 120. A vacuum pump 128 is connected through a pressure controller 124 to a reaction vessel 102 so that the machine is designed for allowing to keep a pressure inside the reaction vessel 102, for example, under a low pressure condition from 1 × 10⁻³ to 1 × 10⁻¹⁰ or under a high pressure condition from 1 × 10² to 10⁷

Gas pipings 111, 112 are connected to the reaction vessel 102 through a flow controller 110 at a place where air, for example, and a carrier gas or a silane compound as the modifier compound can be supplied, that is, the machine is designed so as to allow the carrier gas and the modifier compound 14 to mix adequately and the resultant gaseous mixture to be introduced into the inside area 122 of the reaction vessel 102. The storage tank 12, which stores the modifier compound 14 and has the heater 16 for heating and vaporizing the modifier compound 14 or the pressure gauge 18, is connected to the gas piping 111. A shutter 114 that is openable and closable is placed between the high-frequency wave applying electrode 106 and the earth electrode 120. The degree of surface treatment onto the solid material 116 can be controlled by opening or closing the shutter 114. From these reasons mentioned above, the use of the surface treatment machine 100 enables a sufficient and even treatment of a solid surface by spraying a gaseous mixture under a low pressure to the solid material then carrying out a high-frequency thermal treatment. In addition, by spraying a gaseous mixture under a high pressure to the solid material then carrying out a high-frequency-wave thermal treatment, the use of the surface treatment machine 100 enables a sufficient and even treatment of a solid surface due to a rapid heating of the certain modifier compound, resulting in the reduction of the load posed to the heat source.

### (4) Modified Example 3

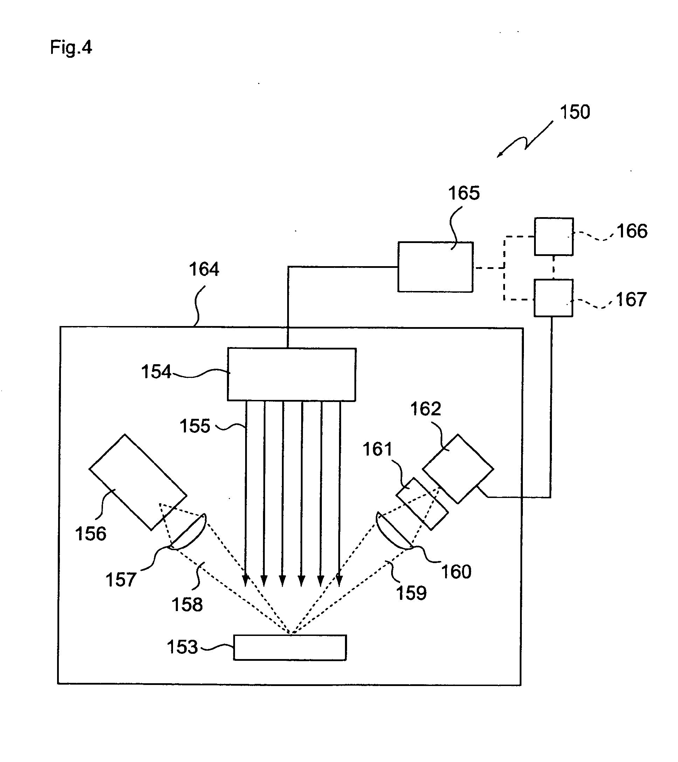

A surface treatment machine 150 having a laser generator 154 as a heat source is also preferably used as another example of the surface treatment machine of the present invention as shown in figure 4.

In Fig.4, spraying apparatus for the modifier compound 14 is not shown, and only the laser generator 154 and the temperature control system therefore are shown. A solid material 153 is placed in a measurement vessel 164 under ambient or vacuum pressure. The solid material 153 is irradiated with a uniform laser ray 155 from a laser generator 154. For example, a solid surface can be heated by use of a synthesizer 165 by radiating a ray periodically at a certain frequency (f). This machine 150 has a probe laser generator 156 from which a probe laser ray 158 with different wavelength from the laser ray 155 is radiated to a spot area after reflected with a focusing lens 157 at the same time of the periodic radiation or the like time. According to this, after the reflected light 159 by the solid surface 153 is focused by a focusing lens 160, the light travels through an optical filter 161 by which wavelength of the light is selected, to an optical sensor 162, photodiode or photocell or the like that can detect the light. The optical filter 161 may be an interference filter or the like that select the light with wavelength corresponding to that of the probe laser ray 158. The optical sensor 162 is connected to, for example, a lock-in amplifier 167 in order to measure the change in temperature at a place where the probe laser ray 158 is irradiated, and a arithmetic logical unit 166 controls the machine according to the change in temperature. From these reasons, according to the surface treatment machine 150 equipped with such laser 154 and the temperature control systemtherefore, it is possible to carry out the laser heating treatment with controlling the temperature, resulting in sufficient and uniform treatment of the solid surface. XeCl eximer laser, for example, is preferably used as a laser at an energy density of 100 to 400 mJ/cm² and repeated its irradiation from 1 to 1000 times.

### (5) Modified Example 4

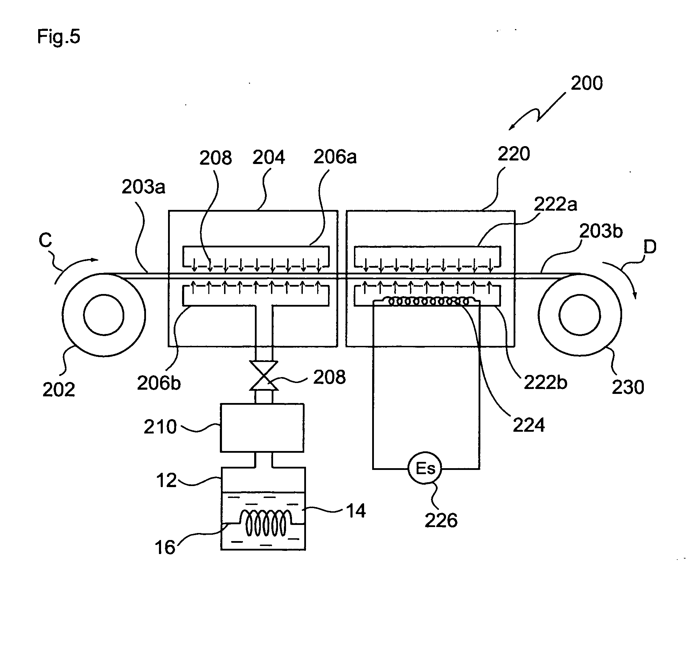

As shown in Fig.5, a surface treatment machine 200 designed for a longitudinal solid material is also preferably used as a modified example, wherein a modifier compound treatment section 204 for spraying-treating a gaseous mixture containing the modifier compound 14 to a solid material 203 and a heating section 220 that heats the gaseous mixture or the solid material to a certain temperature or more with heat source 222a, 222b are arranged in a longitudinal direction. It is preferable to arrange linearly a roller 202 for sending a long article to be treated as a solid material 203a, the other roller 230 for rolling a surface treated longitudinal solid material 203b at each ends, the modifier compound treatment section 204 and the heating section 220 between the rollers. In the figure, the sending or the rolling direction of the longitudinal solid material is indicated by arrow C or arrow D, respectively. Accordingly, this machine 200 makes it possible to carry out a rapid and uniform surface treatment to a solid material even if the solid material is longitudinal solid material with a large area such as a film or a ceramic substrate. In other words, this machine 200 can carry out the rapid and uniform surface treatment while transporting the longitudinal solid material as a solid material 203a by spraying a gaseous mixture containing a certain modifier compound 14, then heating with heat source 224 such as a halogen lamp, infrared lamp, hot air heater or ceramic heater with controlling temperature. The structure of storage tank 12 for vaporizing the modifier compound 14 or the like may be same as the structure as described in the modified example 1.

### [Embodiment 2]

The second embodiment of the present invention is a surface-modified solid material (first solid material), wherein a gaseous mixture comprising a modifier compound containing at least silane atom, titanium atom or aluminum atom is sprayed on the solid surface while the gaseous mixture is heated to 400°C or more with a heat source to make its surface tension (measured at 25°C) to be from 40 to 80 dyn/cm, or a surface-modified solid material (second solid material), wherein a gaseous mixture comprising a modifier compound containing at least silane atom, titanium atom or aluminum atom is sprayed on the solid surface and then the solid material is heated to 400°C or more with a heat source to make its surface tension (measured at 25°C) of 40 to 80 dyn/cm.

### 1. Material

### (1) Rubber or elastomer

A rubber or elastomer may be used as a solid material for the surface treatment of the present invention. Examples of the rubber include silicone rubber, fluoride rubber, natural rubber, neoprene rubber, chloroprene rubber, urethane rubber, acryl rubber, olefin rubber, styrene-butadiene rubber, acrylonitrile-butadiene rubber, ethylene-propylene rubber, ethylene-propylene-diene rubber, butadiene rubber, butyl rubber, thermoplastic elastomer such as styrene elastomer, and urethane elastomer. These rubbers and rubbers may be used alone in a combination of two or more.

Especially, silicone rubber, fluorine rubber, olefin rubber, or ethylene-propylene rubber obtains an excellent modification effect by carrying out the surface modification of the present invention when compared to a conventional surface treatment. For example, a stainproof rubber or cover made of silicone rubber or fluorine rubber can be subject to a printing of a letter or a number or the like on its surface.

### (2) Resin

A resin may be also used as a solid material for the surface treatment of the present invention. Examples of the resin include a polyethylene resin (high density polyethylene, medium density polyethylene, low density polyethylene, high pressure polyethylene, medium pressure polyethylene, low pressure polyethylene, linear low density polyethylene, branched low density polyethylene, normal low density polyethylene at high pressure, super high molecular weight polyethylene, cross-linked polyethylene), polypropylene resin, modified polypropylene resin, polymethylpentene resin, polyester resin, polycarbonate resin, polyether sulfon resin, polyacril resin, polyetheretherketon resin, polyimide resin, polysulfon resin, polystylene resin, polyamide resin, polyvinylchloride resin, polyacrilnitril-butadiene-styrene resin (ABS resin), polyurethane resin, polyphenylene sulfide resin, ethylene-tetrafluoroethylene copolymer, polyvinylfluoride resin, tetrafluoroethylene-perfluoroether copolymer, tetrafluoroethylene-hexafluoropropylene copolymer, polytetrafluoroethylene resin, polyvinylidene fluoride, polytrifluorochloroethylene, and ethylene-trifluorochloroethylene copolymer.

Especially, a polyethylene resin, a polypropylene resin, a polyester resin, a polycarbonate resin, or a polytetrafluoroethylene resin may obtain an excellent modification effect by carrying out the surface modification of the present invention when compared to a conventional surface treatment. For example, a filmmade of polyethylene resin or polypropylene resin or a container made of polyester can be subject to a printing of a letter or a pattern or the like on its surface, a compact diskmade of polycarbonate can be subject to adhesion of aluminum film as a reflecting layer and a stainproof material made of polytetrafluoroethylene resin can be subject to a printing of a letter or a number or the like on its surface.

### (3) Thermosetting resin

A thermosetting resin may be also used as a solid material for the surface treatment of the present invention. Examples of the thermosetting resins include an epoxy resin, phenol resin, cyanate resin, urea resin, and guanamine resin. Epoxy resin as a sealing resin for a semiconductor device, for example, can be easily subject to a laser marking by carrying out the surface treatment of the present invention.

### (4) Metal

A solid material for the surface treatment of the present invention also includes a metal itself or the combination of metals such as aluminum, magnesium, stainless, nickel, chromium, tungsten, gold, copper, iron, silver, zinc, tin, and lead.

These metals may be used alone or in combination of two or more. For example, aluminum, which has been used for applications as a light metal, has a problem that a coating layer formed by applying an UV lacquer is easily peeled off because an oxidized layer is easily formed on the surface of the aluminum. The surface treatment of the present invention to aluminum surface effectively prevents a coating layer formed by a direct application of UV lacquer from peeling off. Magnesium has been recently used for various kinds of casings for a computer or the like as a recyclable metal. However, magnesium poses a problem that a coating layer formed by applying an UV lacquer is easily peeled off. The surface treatment of the present invention to magnesium surface effectively prevents coating layer formed by a direct application of UV lacquer from peeling off. So it becomes possible to provide a colorized magnesium or the like. Moreover, when gold bump or solder bump is connected to a film carrier or a circuit substrate, a problem is observed the boundary separation is generated under a high temperature and high humidity. The surface treatment of the present invention to gold bump or solder bump or to a conductive part of the film carrier or circuit substrate effectively avoids boundary separation.

### (5) Inorganic filler

As an additive for a solid material to be treated by the surface treatment of the present invention, titanium oxide, zirconium oxide, zinc oxide, indium oxide, tin oxide, silica, talc, calcium carbonate, lime, zeolite, gold, silver, copper, zinc, nickel, tin, lead, solder, glass, ceramic or the like may be used alone or in combination two or more. An addition of the inorganic filler improves a physical property of a solid material such as mechanical strength, heatproof, conductivity or electrical insulation according to kind of the filler. The surface of the added inorganic filler is also modified, or sometimes preferentially modified by the surface treatment of the present invention. So a solid material having the filler sometimes shows better surface modification effect by the surface treatment. When the inorganic filler is added to a solid material, the filler is preferably added to from 0.01 to 80 weight % of the whole weight, more preferably from 0.1 to 50 weight % or more preferably 1 to 30 weight %.

### (6) Shape

A solid material as treating solid material is not limited in shape. Examples of the shape of the solid material include a 2-dimentional shapes such as plate, sheet, film, tape, strip, panel, and band and a 3-dimentional shapes such as pipe, column, sphere, block, tube, convex-concave shape, fiber, and batch. The surface treatment of the present invention to glass in fiber shape or carbon fiber modifies and activates its surface, so that the treated glass or carbon fiber can be dispersed into a matrix of an epoxy resin or polyester resin. Fromthisreason, FRP or CFRP excellent in mechanical strength or heatproof can be obtained.

As a solid material for the surface treatment of the present invention, a complex material, mainly made from those solid material mentioned above combined with a metal, ceramic, glass, paper or wood, is preferably used. The surface treatment of the present invention to the inside of a metal pipe or ceramic pipe can activate its surface, so that a pipe having a strongly-adhered resin liner can be obtained. The surface treatment of the present invention to a substrate such as glass or plastic used as a substrate for a liquid-crystal display, organic electroluminescence display, plasma display or CRT results in strong lamination of an organic film such as a color filter, polarization plate, light scattering plate, black matrix plate, anti-reflection layer, and anti-electrostatic layer.

### 2. Gaseous mixture

The same modifier compound and carrier gas as explained in the first embodiment are available. Explanations about them are omitted.

### 3. Heat source

The same heat source as explained in the first embodiment is available. Explanation about it is omitted.

### 4. Wettability (surface tension)

The effect of the surface treatment of the present invention usually provides a solid surface with surface tension ranging from 40 to 80 dyn/cm at 25°C and the effect within this range is preferably set to an aimed value. Sometimes, the effect is more than 80 dyn/cm, and sometimes less than 40dyn/cm, depending to a kind of the solid material. To obtain a solid material having a surface tension of more than 80 dyn/cm, the treated surface may have intention to be deteriorated by heat. By contrast, it is easy to obtain a solid material having the surface tension less than 40 dyn/cm. However, the surface often does not show enough properties suitable for an adhesion, printing or coating. To avoid such undesired effects, the solid material is preferably treated to have surface tension in the range from 45 to 75 dyn/cm, more preferably in the range of 50 to 70 dyn/cm. In addition, the solid material having surface tension within such ranges is useful for adhesion, printing or coating. The surface tensions of a solid material before or after surface-treated are shown in Table 2.

### Examples

### Example 1

### 1. Surface modification of solid material

A sheet (100cm²) of silicone rubber (stiffness 80) with 2mm in thickwasprepared. Next, the silicone rubber sheet was a surface-treated for 0.5 sec using a surface treatment machine shown in Fig. 1 with a gaseous mixture containing a modifier compound heated with a ceramic heater to 700°C. A gaseous mixture in a cartridge consisting of 0.0001 mol% of tetramethylsilane (b.p. 27°C), 0.00001 mol% tetramethoxysilane (b.p. 122°C), and compressed air as the rest is used as a gaseous mixture containing modifier compound.

### 2. Examination of Solid Material

### (1) Wettability (surface tension)

The surface tension of the surface-modified silicone rubber is measured by use of standard solution. Also, the surface tension of the original silicone rubber is measured.

### (2) UV coating property

The surface-treated silicone rubber sheet is screen-printed with an UV lacquer comprising an epoxy acrylate and then irradiated with ultraviolet ray at 300mJ/cm² by UV generator.

The coated sheet is examined for adhesion by the standard as follows. The silicone rubber sheet, which is not modified by the surface treatment, is examined for adhesion with UV lacquer.
Very good : No peeling was observed at 100 areas by 1mm cross cut (JIS standard).
Good :1 to 2 peelings were observed by at 100 areas by 1mm cross cut (JIS standard) .
Fair : 3 to 10 peelings were observed at 100 areas by 1mm cross cut (JIS standard) .
Bad : 11 or more peelings were observed at 100 areas by 1mm cross cut (JIS standard).

### Examples 2 to 7

In Examples 2 to 7, the surface treatments were carried out to various kinds of solid materials and for various periods of time and then coated with the UV lacquer, followed by evaluating the surface-modified solid materials for adhesion as does in Example 1, respectively.

### Comparative Examples 1 and 2

The surface modification to solid surfaces and modified solid materials were carried out by the same way as that of Example 1, except that the gaseous mixture containing the modifier compound was heated to 300°C or 150°C in Comparative examples 1 and 2, respectively.

**Table 1**

| | solid material | temperature (°C) | time (sec) | Surface tension (dyn/cm) | | UV coating probativity | |
|---|---|---|---|---|---|---|---|
| | | | | before treatment | After treatment | Before treatment | after treatment |
| Example 1 | Silicone rubber | 700 | 0.5 | 30 | 60 | Bad | Very Good |
| Example 2 | Silicone rubber | 700 | 0.2 | 30 | 52 | Bad | Good |
| Example 3 | polyethylene plate | 500 | 1.0 | 32 | 64 | Bad | Very Good |
| Example 4 | PET film | 500 | 0.2 | 38 | 64 | Fair | Very Good |
| Example 5 | Magnesium plate | 700 | 0.5 | 34 | 60 | Bad | Very Good |
| Example 6 | stainless plate | 700 | 0.5 | 34 | 60 | Bad | Very Good |
| Example 7 | Aluminum plate | 700 | 0.5 | 32 | 60 | Bad | Very Good |
| Comparative Example 1 | Silicone rubber | 300 | 0.5 | 30 | 48 | Bad | Fair |
| Comparative Example 2 | Silicone rubber | 150 | 0.5 | 30 | 30 | Bad | Bad |
| *PET film:polyethylene terephthalate film | | | | | | | |

### Examples 8 to 10 and Comparative Examples 3

In Example 8, after carrying out the surface treatment by the same way as that of Example 1, the solid materials were left unattached for 2 or 4 weeks. Subsequently, each of them was examined for surface tension and UV coating property. A tetramethylsilane-compressed air mixture was used as a gaseous mixture in Example 9, a hexamethyldisilazane-compressed air mixture was used as a gaseous mixture in Example 10, and a hexamethyldisiloxane-compressed air mixture was used as a gaseous mixture in Example 11. After carrying out the surface treatment by the same way as that of Example 1, these solid materials in Examples 9 to 11 were left unattached for 2 or 4 weeks. Subsequently, each of them was examined for surface tension and UV coating property. In Comparative Example 3, after carrying out a corona treatment for 10 sec instead of the surface treatment of the present invention, a treated solid material was left unattached for 2 or 4 weeks and then it was examined for surface tension and UV coating property.

**Table 2**

| | solid material | temperature (°C) | time (sec) | Surface tension (dyn/cm) | | UV coating probativity | |
|---|---|---|---|---|---|---|---|
| | | | | 2week | 4week | 2week | 4week |
| Example 8 | Stainless plate | 700 | Gaseous mixture A 0.5sec | 60 | 58 | Very Good | Good |
| Example 9 | Stainless plate | 1,000 | Gaseous mixture B 0.5sec | 60 | 61 | Very Good | Very Good |
| Example 10 | Stainless plate | 1,000 | Gaseous mixture C 3sec | 63 | 62 | Very Good | Very Good |
| Example 11 | Stainless plate | 1,000 | Gaseous mixture D 1sec | 65 | 65 | Very Good | Very Good |
| Comparative Example 3 | stainless plate | - | Corona treatment 10sec | 30 | 30 | Bad | Bad |
| *gaseous mixture A (tetramethylsilane and tetramethoxysilane) | | | | | | | |
| *gaseous mixture B (tetramethylsilane) | | | | | | | |
| *gaseous mixture C (hexamethyldisilazane) | | | | | | | |
| *gaseous mixture D (hexametyldisiloxane) | | | | | | | |

### Industrial Applicability

According to the surface treatment method of the present invention, a method, wherein a gaseous mixture containing a certain modifier compound is sprayed on the solid surface while the gaseous mixture is heated to a certain temperature or more with a heat source, or another method, wherein gaseous mixture containing a certain modifier compound is sprayed on the solid surface then the solid surface is heated to a certain temperature or more, is used alone or in combination, and these method enable to provide a surface-treated solid material to which adhesion, printing coating or the like can be easily applied, without being contacted directly with a flame or without any flame. According to a surface-treated solid material of the present invention, a non-adhesive material such as silicone rubber, fluorine rubber, olefin rubber, or polyester resin, or a metal such as stainless or magnesium can be subject to adhesion, printing, coating or the like, which is conventionally difficult.

## Claims

1. A method of modifying a solid surface, wherein
a gaseous mixture comprising a modifier compound containing at least a silane atom, a titanium atom, or an aluminum atom is sprayed on the solid surface while the gaseous mixture is heated to 400°C or more with a heat source, or
a gaseous mixture comprising a compound containing at least silane atom, titanium atom or aluminum atom is sprayed on the solid surface, followed by heating the solid surface to 400°C or more with a heat source.

2. A method of modifying a solid surface, wherein
a gaseous mixture comprising a modifier compound containing at least a silane atom, a titanium atom, or an aluminum atom is sprayed on the solid surface while the gaseous mixture is heated to 400°C or more with a heat source, and
the solid surface is then heated to 400°C or more with the heat source or with an additional heat source.

3. A method of modifying a solid surface according to Claim 1 or 2, wherein
the heat source is at least one heating device selected from a group consisting of a laser, a halogen lamp, an infrared lamp, a high-frequency coil, an induction heating apparatus, a hot air heater, and a ceramic heater.

4. A method of modifying a solid surface according to anyone of Claims 1 to 3, wherein
the modifier compound is selected from a group consisting of alkyl silane, alkoxy silane, alkyl titanium, alkoxy titanium, alkyl amine, and alkoxy aluminum.

5. A method of modifying a solid surface according to anyone of Claims 1 to 4, wherein
the modifier compound in the gaseous mixture has a content of 1 × 10⁻¹⁰ to 10 mol% with respect to 100 mol% of the gaseous mixture in total.

6. A method of modifying a solid surface according to anyone of Claims 1 to 5, wherein
the gaseous mixture is prepared by mixing the modifier compound with air.

7. A method of modifying a solid surface according to anyone of Claims 1 to 6, wherein
the gaseous mixture is sprayed at a low pressure of 1 × 10⁻³ Pa to 1 × 10⁻¹⁰ Pa.

8. A method of modifying a solid surface according to anyone of Claims 1 to 7, wherein
the gaseous mixture is sprayed at a high pressure of 1 × 10² Pa to 1 × 10⁷ Pa.

9. A method of modifying a solid surface according to anyone of Claims 1 to 8, wherein
the gaseous mixture is sprayed for 0.1 sec to 100 sec per unit area (100cm²).

10. A surface-modified solid material, prepared such that
a gaseous mixture comprising a modifier compound containing at least a silane atom, a titanium atom or an aluminum atom is sprayed on the surface of a solid material while the gaseous mixture is heated to 400°C or more with a heat source or
a gaseous mixture comprising a modifier compound containing at least a silane atom, a titanium atom or an aluminum atom is sprayed on the surface of a solid material, followed by heating the surface of the solid material to 400°c or more with a heat source, whereby
the resulting surface-modified solid material has a surface tension (measured at 25°C) of 40 to 80 dyn/cm.

11. A surface-modified solid material, prepared such that a gaseous mixture comprising a modifier compound containing at least a silane atom, a titanium atom or an aluminum atom is sprayed on the surface of a solid material while the gaseous mixture is heated to 400°C or more with a heat source and then the solid material sprayed with the gaseous mixture is heated to 400°C or more with the heat source or another heat source whereby the resulting surface-modified solid material has a surface tension (measured at 25°C) of 40 to 80 dyn/cm.
